Europäisches Patentamt

(19) **European Patent Office**

**Office européen des brevets**

(11) Publication number: **0 119 060**

**A2**

(12) # EUROPEAN PATENT APPLICATION

(21) Application number: **84301531.4**

(22) Date of filing: **08.03.84**

(51) Int. Cl.³: **H 03 D 1/06**
**H 03 D 1/10**

(30) Priority: **10.03.83 GB 8306560**

(43) Date of publication of application:
**19.09.84 Bulletin 84/38**

(84) Designated Contracting States:
**DE FR GB**

(71) Applicant: **BRITISH AEROSPACE PUBLIC LIMITED COMPANY**
**100 Pall Mall**
**London SW1Y 5HR(GB)**

(72) Inventor: **Hemingway, Thomas Keith British Aerospace P.L.C.**
**Dynamics Group Six Hills Way**
**Stevenage Hertfordshire SG1 2DA(GB)**

(72) Inventor: **Everest, Frank Geoffrey British Aerospace P.L.C.**
**Dynamics Group Six Hills Way**
**Stevenage Hertfordshire SG1 2DA(GB)**

(74) Representative: **Dowler, Edward Charles et al,**
**British Aerospace Public Limited Company Corporate Patents Department Brooklands Road**
**Weybridge Surrey, KT13 OSJ(GB)**

(54) **AM detectors/demodulators.**

(57) An amplitude modulation detector usually comprises a rectifier diode or equivalent element feeding a capacitive load. To ensure linearity, the minimum carrier amplitude, *i.e.* in the troughs of the amplitude modulation, must exceed the non-linear range of the diode. In turn, this may mean that the carrier amplitude at the waveform peaks are inconveniently high, particularly for high frequency carriers. The detector disclosed herein comprises an amplifier for receiving the carrier, a circuit for detecting and actively integrating the output of the amplifier and a negative feeedback network connected between the output of the detector/integrator circuit and the amplifier input such that the amplifier output comprises a current signal indicative of the carrier/feedback voltage difference. As a result, linear demodulation is achievable for quite low RF amplitudes.

EP 0 119 060 A2

TITLE:   AM DETECTORS/DEMODULATORS

When detecting a signal which is present as amplitude modulation of a relatively high frequency carrier wave, it is usually desirable that the detected ("demodulated") output be a linear representation of the original ("modulating") signal.

The usual demodulator uses a diode, or an active equivalent, such as an emitter follower, together with a capacitive load.  Provided the time constant of the load is large compared with the carrier period and small compared with the modulating signal, the output approximates to the modulating signal.  However, there is a serious disadvantage to this basic circuit, well known to those practised in the art, namely that the practical diode has a non ideal characteristic.  In particular, it needs a certain minimum voltage around 0.2 volts before conduction begins and it has a square law characteristic at low levels.

This results in unfaithful reproduction of the modulation for low signal levels.   To obtain linear demodulation it is evident that it is desirable to forward bias the diode slightly and to operate at as high a level of signal as possible.   In practice, operation become linear to a few percent for signals exceeding 200 mV peak; in the case of a modulated carrier the waveform troughs should therefore exceed this figure and if a working linear range of 30dB (for example) is needed then the peaks of the waveform would reach 6V.

Such levels are often inconveniently high either because of supply voltage limitations or in the case of high frequency carriers (e.g. 35 MHz), the difficulty of raising the hf signal to this level.

Properly designed, the detectors described and illustrated herein may enable linear demodulation to be achieved at much lower levels (> 20 mV) without the use of special detector diodes. Also these detectors may be implemented in a form suitable for incorporation in an integrated circuit.

According to the invention, there is provided an amplitude-modulation detector comprising amplifier means having an input for receiving an amplitude-modulated RF signal and an input for receiving a feedback signal and being operable for forming a current signal corresponding to the difference between said RF signal and said feedback signal, a detection and integration circuit for detecting and actively integrating said current signal, and feedback means for deriving said feedback signal from the output of said detection and integration circuit.

For a better understanding of the invention, reference will be made, by way of example, to the accompanying drawing, in which:-

figure 1 is a simplified diagram of an AM detector, and

figure 2 is a circuit diagram of a practical realisation of the figure 1 detector.

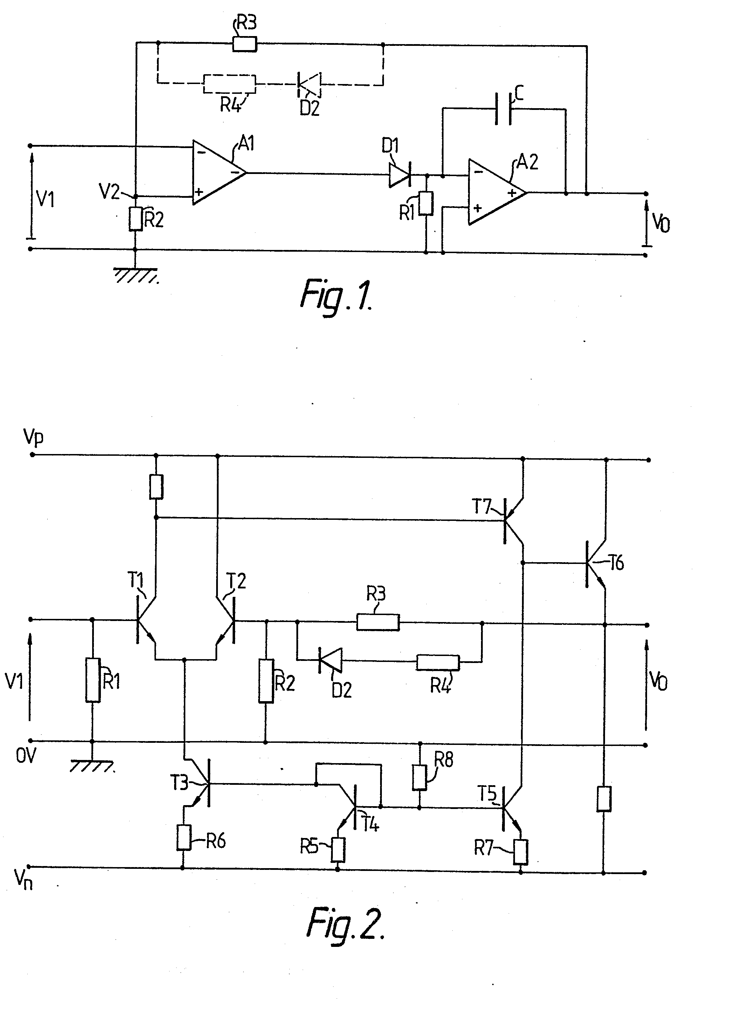

In figure 1, a modulated RF carrier V1 is connected to the inverse input of a differential amplifier of a type producing output current as a function of differential input voltage. The current output is fed _via_ a diode D1 and an active integrator to the other input of the differential amplifier, the integrator comprising amplifier A2, feedback capacitor C1 and resistor R1. Thus, the feedback voltage V2 follows the modulation of the input carrier, because any discrepancy between the V1 peaks and V2 results in one-way current into the integrator and hence an adjustment to V2.

To a first order, the non-linearity of D1 is unimportant. The integrator must be unable to follow the carrier frequency, but must follow the modulation frequency.

V2 will follow V1 for low frequencies including zero frequency, behaving as a normal amplifier. Thus the same circuit will give the same results whether a low frequency input signal is presented or whether that signal is amplitude modulating a carrier, provided the two frequencies are in a suitable range for the integrator. This feature, if desired, can be removed by introducing a capacitor coupling at the input for V1 to provide a low-frequency cut off.

Resistors R3 and R2 can be included as shown so that the output voltage $V_0 = V_1 (R_2 + R_3)/R_2$, giving defined gain. The presence of these resistors also enables shaping to be provided, for example by the addition of diode D2 and resistor R4 shown in dashed lines, to modify the transfer characteristic.

No tuned circuits are used in figure 1. In practice, C can be an intrinsic transistor capacitance so that no actual capacitors are used. This makes the configuration ideal for an integrated circuit design.

In the practical implementation of figure 4, transistors T1 and T2 form a differential amplifier and T7 is a slow PNP device acting as an integrator, amplifier and detector. Diode connected transistor T4 is driven by resistor R8 and itself drives transistors T3 and T5 in current mirror fashion, the actual division of currents being defined by resistors R5, R6 and R7. Transistors T3 and T5 provide high impedance loads for T1/T2 emitter circuit and T7 collector circuit respectively. Transistor T6 is a buffer to maintain the high voltage gain of T7 while driving feedback resistor R3.

The figure 4 circuit may be suitable for incorporation into an integrated circuit, utilising as it does the inherent Vbe balance between T1 and T2 and between T3, T4 and T5, and using a 'lateral' PNP device T7 which effectively contains C, since its $F_T$ is low and its $C_{CB}$ high. The circuit operates over carrier frequencies of approximately 10 to 80 MHz, modulation from zero frequency to 200 KHz, input levels 30 mV to 1V peak. Linearity correction by the combination of diode D2 and resistor R4 gives substantially linear demodulation over this input range.

WE CLAIM:-

1. An amplitude-modulation detector comprising amplifier means having an input for receiving an amplitude-modulated RF signal and an input for receiving a feedback signal and being operable for forming a current signal corresponding to the difference between said RF signal and said feedback signal, a detection and integration circuit for detecting and actively integrating said current signal, and feedback means for deriving said feedback signal from the output of said detection and integration circuit.

2. A detector according to claim 1, wherein said amplifier means comprises two transistors interconnected to form a differential amplifier, the collector of one of the two transistors being connected to the base of a further transistor which is biassed so as to act as a detector and which incorporates appreciable intrinsic capacitance to give an integration effect.

3. A detector according to claim 1, wherein said feedback means comprises a network including resistors and at least one diode.

4. A detector according to claim 1, the detector being constructed in the form of an integrated circuit.

Fig.1.

Fig.2.